**Europäisches Patentamt**

(19) **European Patent Office**

**Office européen des brevets**

(11) Veröffentlichungsnummer: **0 137 323**
**B1**

(12) # EUROPÄISCHE PATENTSCHRIFT

(45) Veröffentlichungstag der Patentschrift:
**29.03.89**

(51) Int. Cl.⁴: **H 03 H 17/06**

(21) Anmeldenummer: **84110763.4**

(22) Anmeldetag: **10.09.84**

(54) Verfahren und Vorrichtung zur Umsetzung einer Eingangsabtastfolge in eine Ausgangsabtastfolge.

(30) Priorität: **06.10.83 CH 5427/83**

(43) Veröffentlichungstag der Anmeldung:
**17.04.85 Patentblatt 85/16**

(45) Bekanntmachung des Hinweises auf die Patenterteilung:
**29.03.89 Patentblatt 89/13**

(84) Benannte Vertragsstaaten:
**AT BE CH DE FR GB IT LI NL SE**

(56) Entgegenhaltungen:
**EP-A-0 099 600**

**FUNKSCHAU, Nr. 2, Januar 1983, MÜNCHEN, (DE), Seiten 54-58, R.LAGADEC: "Digitale Umsetzung von Abtastfrequenzen: UNIVERSAL-GENIE" ELECTRONIC LETTERS, Band 16, Nr. 17, 14. August 1980, Seiten 670-672, HITCHIN HERTS, (GB), R.A. STEIN et al.: "Continuously variable digital filters based om linear interpolation of coefficients"**

(73) Patentinhaber: **WILLI STUDER AG Fabrik für elektronische Apparate, Althardstrasse 30, CH-8105 Regensdorf ZH (CH)**

(72) Erfinder: **Lagadec, Roger, Dr. Dipl.- Ing., Schulstrasse 22, CH- 8153 Rümlang (CH)**
Erfinder: **Koch, Andreas, Dipl.- Ing., Vogelsangstrasse 401, CH- 5426 Lengnau (CH)**
Erfinder: **Pelloni, Daniele, Dr. Dipl.- Ing., Naglerwiesenstrasse 88, CH- 8049 Zürich (DE)**

## Beschreibung

Die Erfindung betrifft ein verfahren und eine Vorrichtung zum Umsetzen der Abtastwerte einer Eingangsabtastfolge, die mit einer Eingangsabtastfrequenz auftreten, in Abtastwerte einer Ausgangsabtastfolge, die mit einer Ausgangsabtastfrequenz auftreten derart, dass die Eingangsabtastfolge und die Ausgangsabtastfolge Frequenzspektren aufweisen, die in einem Frequenzbereich amplitudenmässig im wesentlichen identisch sind, der sich von der Frequenz Null bis zur Hälfte der niedrigeren der beiden Abtastfrequenzen erstreckt.

Ein solches Verfahren und eine solche Vorrichtung sind aus der europäischen Patentanmeldung EP-A-0 052 847 bereits bekannt. Bei diesem Verfahren und bei dieser Vorrichtung geschieht die Umsetzung der Eingangsabtastfolge in die Ausgangsabtastfolge durch mehrmaliges digitales Filtern der Eingangsabtastwerte in einem mehrstufigen digitalen Filter. Dabei wird die Eingangsabtastfolge in mehreren Schritten in die Ausgangsabtastfolge uebergefuehrt. Dieser vorgang wird gesteuert durch die momentane zeitliche Differenz zwischen dem Eingangs- und dem Ausgangsabtastzeitpunkt. Diese Differenz wird zur Berechnung eines momentanen Filterkoeffizientensatzes verwendet. Ein wichtiger Teil dieser Vorrichtung ist deshalb zur Ermittlung dieser zeitlichen Differenz vorgesehen.

Bisher bekannte Vorrichtungen zur Ermittlung der zeitlichen Differenz zwischen Eingangs- und Ausgangsabtastzeitpunkten können bei rasch wechselnden Eingangs- und Ausgangsabtastfrequenzen nicht folgen. Dies einerseits weil der Zwischenspeicher bei einem mehrstufigen Abtastratenwandler klein ist. Andererseits fuehrt die Verarbeitung von zeitlich variierenden Abtastfrequenzen zu Zeitdifferenzen zwischen den momentan effektiv vorhandenen Abtastwerten und den errechneten Zeitdifferenzen zwischen den betreffenden Ein- und Ausgangsabtastwerten. Deshalb kann bei rasch wechselnden Abtastfrequenzen der Zwischenspeicher nicht mehr genuegend Abtastwerte Zwischenspeichern, was bedeutet, dass die Vorrichtung ihre Funktion nicht mehr erfuellen kann. Ein weiterer Nachteil des mehrstufigen Abtastratenwandlers ist darin zu sehen, dass bei kontinuierlich wechselnden Eingangs- und Ausgangsabtastfrequenzen, wobei sowohl die Eingangs als auch die Ausgangsabtastfrequenz abwechselnd höhere Werte annehmen kann, die Arbeitsfolge der einzelnen Stufen des mehrstufigen digitalen Filters vertauscht werden muss, was nicht ohne Arbeitsunterbruch erfolgen kann.

Die Erfindung wie sie in den Ansprüchen gekennzeichnet ist, löst die Aufgabe ein Verfahren und eine Vorrichtung zu schaffen, die zur Umsetzung wechselnder Eingangs- und Ausgangsabtastraten geeignet sind und die mit einem begrenzten Rechen- und Speicheraufwand auskommen.

Die durch die Erfindung erreichten Vorteile sind im wesentlichen darin zu sehen, dass Abtastfolgen verarbeitet werden können, die kontinuierlich varierende Abtastfrequenzen aufweisen, und zwar insbesondere auch z. B. wenn die eine Abtastfrequenz die ursprünglich grösser oder kleiner war als die andere Abtastfrequenz sich so verändert, dass sie nun kleiner oder grösser als die andere Abtastfrequenz wird. Durch diese Vorrichtung kann ein Signal mit einer zeitvariablen Abtastrate in ein Signal mit einer beliebigen anderen zeitvariablen oder konstanten Abtastrate umgewandelt werden. Es können Filter zur Anwendung vorgesehen werden, deren Filterordnung kleiner ist, als die totale Filterordnung eines mehrstufigen Filters. Dies verringert den Aufwand für die Koeffizientenspeicherung und die Berechnung der neuen Abtastwerte.

Im folgenden wird die Erfindung anhand von einen Ausführungsweg darstellenden Zeichnungen näher erläutert. Es zeigen:

Figur 1 eine Eingangsabtastfolge eines Signales,
Figur 2 die Fiterkoeffizienten eines digitalen Filters,
Figur 3 eine Ausgangsabtastfolge des Signals,
Figur 4 eine Vorrichtung zur Wandlung von Abtastfolgen in schematischer Darstellung,
Figur 5 eine Schaltung zur Kompensation von Zeitdifferenzen,
Figur 6 eine Interpolationsschaltung,
Figur 7 und 8 je ein Filter.

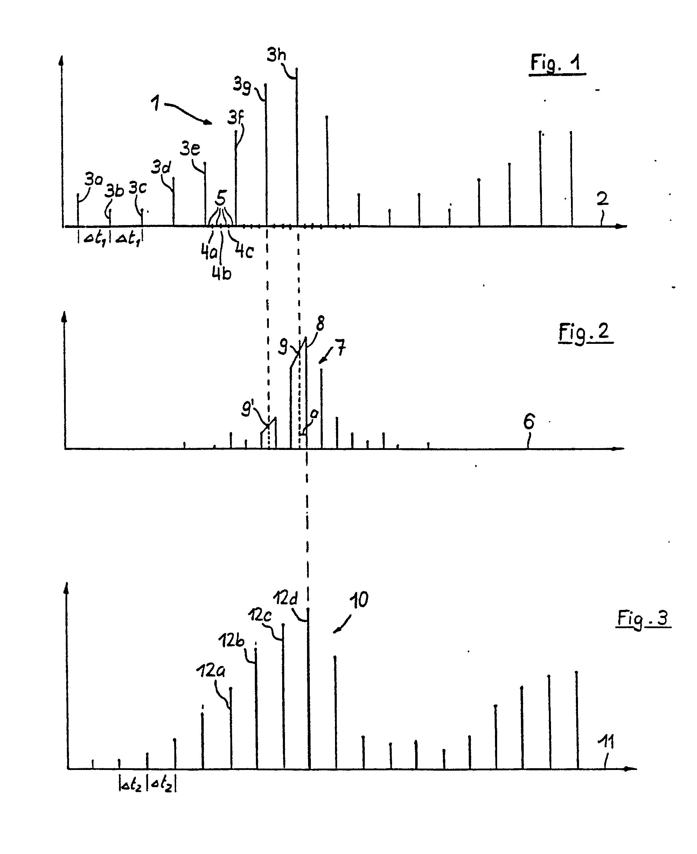

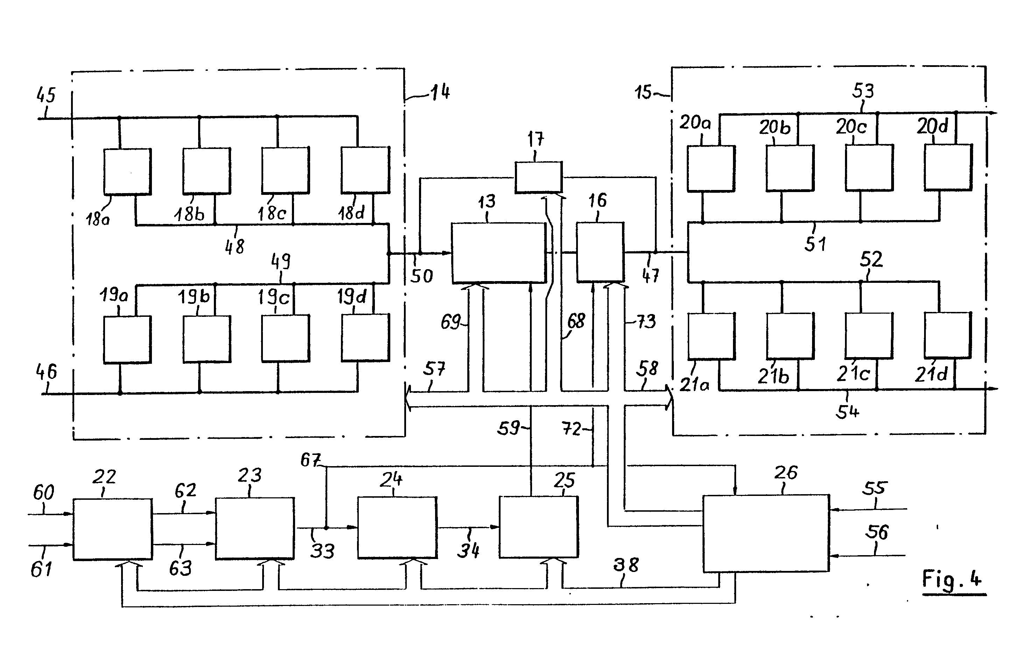

In Figur 1 ist eine Eingangsabtastfolge 1 über einer Zeitachse 2 aufgetragen. Die einzelnen Abtastwerte 3a, 3b. 3c usw. folgen einander in Zeitabständen $\Delta t_1$. Auf der Zeitachse 2 sind weitere Abtastwerte 4a, 4b. 4c usw. ersichtlich, die sich in Zeitabständen 5 folgen, die wesentlich kleiner sind als $\Delta t_1$. Die Signalamplitude dieser weiteren Abtastwerte sei null. Eine Eingangsabtastfrequenz $\omega_1$ ergibt sich dementsprechend aus dem Kehrwert von $\Delta t_1$.

In Figur 2 sind über einer Zeitachse 6 Werte von Filterkoeffizienten 7 eines digitalen und insbesondere transversalen Filters aufgetragen. Mit 8 ist der als Filterachse zu zählende Filterkoeffizient bezeichnet. Ferner sind Werte von Koeffizienten 9,9', die aus einer Interpolation gewonnen werden eingetragen.

Figur 3 zeigt eine Ausgangsabtastfolge 10 über einer Zeitachse 11 aufgetragen mit Abtastwerten 12a, 12b, 12c usw., die einander in Zeitabständen $\Delta t_2$ folgen. Eine Ausgangsabtastfrequenz $\omega_2$ ergibt sich dementsprechend aus dem Kehrwert von $\Delta t_2$.

Figur 4 zeigt eine Vorrichtung zur Umsetzung einer Eingangsabtastfolge in eine Ausgangsabtastfolge bestehend aus einem einzigen, einstufigen digitalen Filter 13, vorzugsweise als Transversalfilter ausgebildet. Beideseits des Filters 13 sind Speicher 14 und 15 angeordnet Mit dem Filter 13 in Serie geschaltet ist ferner ein Multiplikator 16 und parallel zu beiden ein Bypass 17. Der Speicher 14 besteht aus je zwei Gruppen 18, 19 von parallel geschalteten Speichereinheiten bzw. Registern 18a, b, c, d und 19a, b, 19c, 19d. Die eine Gruppe 18 speichert Abtastwerte eines ersten, die andere Gruppe 19 speichert die Abtastwerte eines zweiten Kanals. Genauso ist auch der Speicher 15 aus Gruppen 20, 21 von Speichereinheiten 20a, 20b, 20c, 20d und 21a, 21b, 21c, 21d für zwei Kanäle organisiert.

Zur Aufbereitung der Filterkoeffizienten für das Filter 13 ist ferner eine Schaltung bestehend aus einer Zeitmeßschaltung 22, einer Kompensationsschaltung 23, einer Modulobildungsschaltung 24 und einer Interpolationsschaltung 25, vorgesehen. Eine Steuerung 26 dient der Steuerung der Funktionsabläufe in den einzelnen Elementen der Vorrichtung.

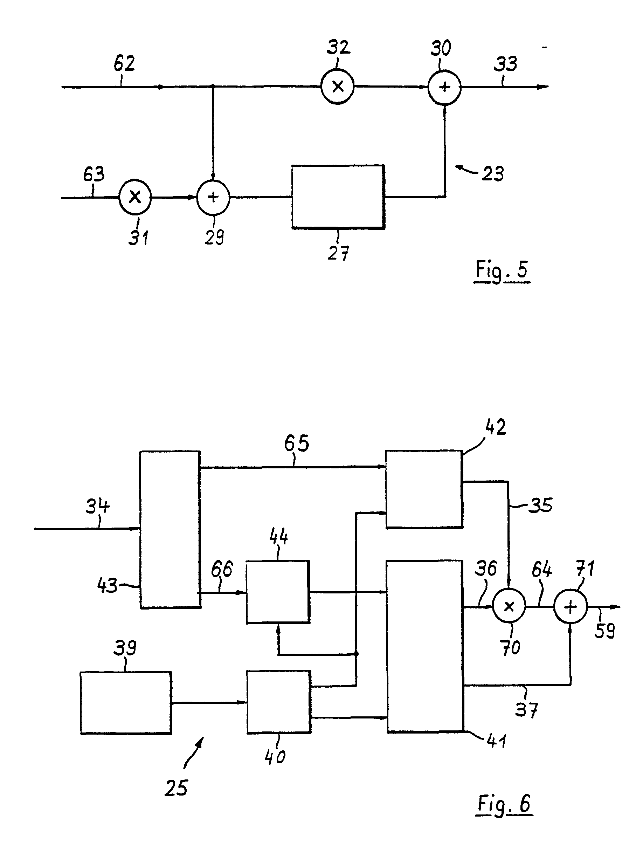

Figur 5 zeigt teilweise den Aufbau der Kompensationsschaltung 23, mit einem Kompensationsfilter 27 und zwei Additionsgliedern 29 und 30 und wei Multiplikatoren 31 und 32.

Diese Kompensationsschaltung 23 weist zwei Eingänge 62 und 63 sowie einen Ausgang 33 auf.

Figur 6 zeigt schematisch den Aufbau der Interpolationsschaltung 25. Darin ist ein Zähler 39 einem Speicher 40 vorgeschaltet, welcher wiederum mit zwei weiteren Speichern 41 und 42 verbunden ist. Eine Teilschaltung 43 sowie ein Inverter 44 sind den Speichern 41 und 42 vorgeschaltet. Leitungen 35, 36 und 37 bilden die Ausgänge der Speicher 41 und 42. Die Leitungen 35 und 36 münden in einen Multiplikator 70, dessen Ausgang 64 wiederum zusammen mit der Leitung 37 in das Additionsglied 71 mündet.

Für die Beschreibung der Wirkungsweise des Verfahrens bzw. der Vorrichtung sind zwei verschiedene Betriebszustände zu unterscheiden:

a) Die Ausgangsabtastrate ist höher als die Eingangsabtastrate $\omega_2 > \omega_1$

b) Die Ausgangsabtastrate ist kleiner als die Eingangsabtastrate $\omega_2 > \omega_1$

Zuerst Fall a):
Dabei gelangen Abtastwerte 3a, 3b, 3c usw. einer Eingangsabtastfolge 1 beispielsweise von zwei getrennten Kanälen eines Audio-Wiedergabegerätes über Leitungen 45 und 46 in den Speicher 14. Jeder der eintreffenden Abtastwerte der Eingangsabtastfolge 1 gelangt in eine der Speichereinheiten 18, a, b, c, d oder 19, a, b, c, d. Dabei nehmen diese Speichereinheiten jeweils nur einen einzigen Abtastwert 3a, 3b, 3c usw. für kurze Zeit auf. Wie später noch genauer beschrieben wird, werden die Abtastwerte anschließend über Leitungen 48, 49 und 50 dem Filter 13 zugeleitet, wo sie verarbeitet werden und verlassen diesen über Leitung 47 als Ausgangsabtastfolge 10. Im Speicher 15 kann diese Ausgangsabtastfolge 10 wieder aufgeteilt werden in getrennte Ausgangsabtastfolgen für 2 getrennte Kanäle. Dazu wird die Ausgangsabtastfolge 10 über Leitungen 51 und 52 den Speichereinheiten 20a, b, c, d und 21a, b, c, d zugeleitet und verlässt diese über Leitungen 53 und 54.

Der Steuerung 26 wird am Eingang 55 die Eingangsabtastfrequenz $\omega_1$, und am Eingang 56 die Ausgangsabtastfrequenz $\omega_2$ zugeleitet. Über den Steuerbus 57 und 58 gibt sie Steuerbefehle an die Speicher 14 und 15 ab. Innerhalb dieser Speicher 14 und 15 werden die Steuerbefehle in an sich bekannter und deshalb hier nicht näher dagestellter Weise an die beiden einzelnen Speichereinheiten 18, 19, 20, 21 weitergeleitet. Dabei werden die Ausgangsabtastwerte 12a, 12b, 12c usw. genau mit der gewünschten Ausgangsabtastfrequenz synchronisiert. Das bedeutet, dass die einzelnen Abtastwerte die Speichereinheiten 20 und 21 nur durchlaufen und dass die Eingangsabtastwerte in den Speichereinheiten 18 und 19 solange verweilen, bis sie durch die Steuerbefehle abgerufen und dem Filter 13 zugeführt werden. In diesem Betriebsfall hat der Speicher 15 somit keine eigentliche Funktion zu erfüllen Die Steuerung 26 synchronisiert die Tätigkeit des Filters 13 auf die Ausgangsabtastfolge 10.

Fall b):
Die Eingangsabtastwerte 3a, 3b, 3c usw. gelangen wiederum über die Leitun gen 45 und 46 in den Speicher 14, durchlaufen diesen sowie anschliessend das Filter 13. Im Multiplikator 16 werden die eintreffenden Ausgangsabtastwerte mit einem Verhältniswert aus der Eingangs- und Ausgangsabtastfrequenz multipliziert. Entsprechende Instruktionen werden dem Multiplikator 16 über den Steuerbus 73 zugeleitet. Die Ausgangsabtastwerte 12a, 12b, 12c usw. gelangen dann über Leitung 47 in den Speicher 15, wo sie durch die einzelnen Speichereinheiten 20a, b, c, d und 21a, b, c, d aufgenommen werden.

In diesem Fall synchronisiert die Steuerung 26 die Tätigkeit des Filters 13 auf die Eingangsabtastfolge 1. Das bedeutet, dass die Eingangsabtastwerte 3a, 3b, 3c usw. die Speichereinheiten 18a, b, c, d und 19a, b, c, d einfach durchlaufen und nach der Behandlung im Filter 13 in den Speichereinheiten 20a, b, c, d und 21a, b, c, d des Speichers 15 gespeichert werden. Dort bleiben sie, bis die Steuerung 26 Ausgabebefehle an den Speicher 15 erteilt. Die Ausgabe der Ausgangsabtastwerte 12a, b, c usw. erfolgt dann synchron zur Ausgangsabtastfolge 10.

Am Beispiel des Falles a) soll nun auch die Wirkungsweise des Filters 13 sowie der Schaltung 22 bis 25 zur Aufbereitung der Filterkoeffizienten 9, 9' erläutert werden.

Die Wirkungsweise des Filters 13 geht aus den Figuren 1 bis 3 hervor. Zuerst wird die Eingangsabtastfolge 1 mit weiteren Abtastwerten 4a, 4b, 4c usw. versehen. Beispielsweise werden zwischen zwei Abtastwerten 3a und 3b, $2^7$ weitere Abtastwerte beigegeben. Dies ergibt einen Raster, der fein genug ist, um die Einstellung des Filters 13 in diesem Raster mit geringsten Fehlern in bezug auf einen Ausgangsabtastwert vollziehen zu können.

Die Ausgangsabtastfolge 10 ist in bezug auf ihre Ausgangsabtastfrequenz $\omega_2$ und die Phasenlage ihrer Abtastwerte 12a, 12b. 12c usw. als gegeben zu betrachten. Gesucht ist die Signalamplitude der Abtastwerte 12, 12b, 12c usw.

Zur Verarbeitung der Eingangsabtastfolge 1 wird nun das digitale Filter 13 auf einem Raster mit den Abtastwerten 4a, 4b usw. so eingestellt, dass die Filterachse 8 (Fig. 2) der Reihe nach mit jedem der Abtastwerte 12a, 12b, 12c usw. der Ausgangsabtastfolge 10 in möglichst gleicher Phasenlage erscheint. In dieser Phasenlage erzeugt das Filter 13 einen Wert für die Signalamplitude des betreffenden Abtastwertes. Hier in den Figuren 1 bis 3 trifft dies für einen Abtastwert 12d zu.

Wie aus den Figuren 1 bis 3 hervorgeht, stimmt die Phasenlage der Filterkoeffizienten 7 nicht mit der Phasenlage der Eingangsabtastwerte 3a, 3b, 3c, usw. überein. Das Resultat einer solchen Filterung er gäbe für den Abtastwert 12d eine Signalamplitude von null, was sicher nicht richtig ist. Dieser Fehler könnte durch ein Filter mit einer unendlich grossen Zahl von Filterkoeffizienten behoben werden. Dies ergäbe aber auch einen unendlich hohen Rechenaufwand, was praktisch nicht brauchbar ist.

Im Gegensatz dazu weist unser Filter 13 eine sehr beschränkte Anzahl von Filterkoeffizienten 7 auf, beispielsweise deren 6399, 3839, 6655.. je nach Anwendung der Vorrichtung für Rundfunk, Studio oder Rundfunk und Studio-Aufnahmen. Dabei berechnet sich die Filterordnung bzw. die Anzahl der gespeicherten Filterkoeffizienten 7 als das Produkt aus der Anzahl der zusätzlichen Abtastwerte 4a, b, c, beispielsweise $2^7$ und der Anzahl der Eingangsabtastwerte 3, z. B. 50.30.52 oder 56 der Eingangsabtastfolge 1, die für die Berechnung eines Ausgangsabtastwertes herangezogen werden, minus eins.

Für alle Abtastwerte der Eingangsabtastfolge 1, die nicht in Phase sind mit Filterkoeffizienten 7 des auf einen bestimmten Abtastwert der Ausgangsabtastfolge 10 eingestellten Filters 13, müssen neue Filterkoeffizienten durch Interpolation gewonnen werden. Beispielsweise gilt dies in Figur 1 und 2 für die Abtastwerte 3g und 3h, für die neue Filterkoeffizienten 9 und 9' errechnet werden müssen. Dies kann durch lineare Interpolation zwischen zwei Stützstellen bzw. Filterkoeffizienten 7 oder durch quadratische Interpolation zwischen drei Filterkoeffizienten 7 geschehen. Für die Interpolation höherer Ordnung werden entsprechend mehr Filterkoeffizienten 7 berücksichtigt.

Anstelle einer Interpolation zwischen gespeicherten Filterkoeffizienten können die Filterkoeffizienten des Filters 13 auch für beliebige Werte aus einer Prototyp-Funktion, welche mit einer Fenster-Funktion multiplikativ gekoppelt ist, gewonnen werden. Gespeichert sind lediglich die Konstanten der betreffenden Funktionen. Berechnet werden jeweils diejenigen Funktionswerte, die zeitlich mit den Eingangsabtastwerten zusammenfallen. Eine mögliche solche Prototyp-Funktion heisst $\frac{\sin(pT)}{nT}$.

Diese interpolierten Filterkoeffizienten werden für den Filter 13 laufend in den Schaltungen 22 bis 25 berechnet und dem Filter 13 über Leitung 59 zugeführt. Das Filter 13 an sich arbeitet aber wieder in bekannter Weise.

Zur Aufbereitung der Filterkoeffizienten 7 wird der Zeitmeßschaltung über den Eingang 60 die Eingangsabtastfrequenz $\omega_1$ und über den Eingang 61 die Ausgangsabtastfrequenz $\omega_2$ zugeleitet. Der Aufbau einer solchen Zeitmeßschaltung 22 ist beispielsweise aus der Europäischen Patentanmeldung Nr. 0 084 592 bekannt. Die Zeitmeßschaltung 22 berechnet das Verhältnis der Zeitdifferenzen zwischen zwei Abtastwerten 3a, b und 12a, b der Eingangs- und der Ausgangsabtastfolge 1 und 10, $\frac{\Delta t_1}{\Delta t}$ für den Fall b) und $\frac{\Delta t_2}{\Delta t}$ für den Fall a).

Dieses Verhältnis wird als 16 Bit-Zahl über Leitung 62 und als 8 Bit-Zahl über Leitung 63 der Kompensationsschaltung 23 zugeführt. Dabei ist diejenige Zahl die über Leitung 62 geleitet wird mit einer grösseren Anzahl vorausgehender Werte gemittelt, wie aus EP-0 084 592 bekannt, während die über die Leitung 63 geleitete Zahl dem mit $2^8$ Zählimpulsen gemessenen Wert entspricht. In der Kompensationsschaltung 23 werden die Werte der Leitungen 62 und 63 jeweils mit 28 multipliziert in Multiplikatoren 31 und 32. Das bedeutet, dass dem Additionsglied 29 16 Bit Zahlen und dem Additionsglied 30 24 Bit Zahlen zugeführt werden. Vor der Multiplikation im Multiplikator 3, werden die 16 Bit Zahlen aus Leitung 62 dem Additionsglied 29 zugeführt, wo sie mit den auf eine 16 Bit-Zahl multiplizierten Werten aus Leitung 63 gemischt werden.

Der Mischwert aus den Leitungen 62 und 63 wird im Kompensationsfilter 27 wiederum genau wie in der Zeitmeßschaltung 22 über mehrere Takte gemittelt und dem Additionsglied 30 zugeführt, wo dieser Wert mit dem ursprünglichen gemittelten Wert aus der Zeitmeßschaltung 22 gemittelt wird. Auf diese Weise kann bei Änderungen der Abtastraten eine schnellere Reaktion der Schaltung herbeigeführt werden, denn es muss nicht abgewartet werden, bis eine genügend grosse Anzahl Werte die Mittelwertbildung in der Zeitmeßschaltung 22 beeinflusst hat. Schon wenige neue Werte können die Zeitmessung nach der Mischung im Additionsglied 29 stark beeinflussen.

Von der Kompensationsschaltung 23 werden die kompensierten Verhältnisse der Zeitdifferenzen der Modulobildungsschaltung 24 zugeführt. Diese besteht aus einer Serieschaltung von einem Register mit einem

Speicherplatz und einer Additionsstufe, wobei nach dem Register eine Rückführung auf die vorausgehende Additionsstufe angeordnet ist. In dieser Modulobildungsschaltung 24 werden zwei nacheinander folgende Werte gemischt und anschliessend an die Interpolationsschaltung 25 abgegeben.

In Erläuterung der Arbeitsweise der Interpolationsschaltung 25 ist nochmals in Erinnerung zu rufen, dass in dem vorliegenden Betriebsfall a) , wo $\omega_2 > \omega_1$ ist, die Filterachse 8 des digitalen Filters 13 mit den Filterkoeffizienten 7 nacheinander auf jeden der Ausgangsabtastwerte 12a , b , c, d usw. eingestellt wird. Zur Berechnung beispielsweise des Ausgangsabtastwertes 12d werden beispielsweise 56 Eingangsabtastwerte nacheinander mit entsprechenden Filterkoeffizienten multipliziert und die Produkte aufsummiert. Dies geschieht im Filter 13 auf an sich bekannte Weise. Welche Filterkoeffizienten 9, 9' usw. aber für jeden dieser 56 Eingangsabtastwerte 3a, 3b usw. zur Anwendung gelangen, bestimmt beispielsweise die Interpolationsschaltung 25.

Zu diesem Zweck startet die Steuerung 26 für jeden dieser Takte, in denen beispielsweise diese 56 Multiplikationen durchgeführt werden, über den Steuerbus 38 den Zähler 39 (Fig. 6). Dieser gibt nun laufend v-Werte (z. B von 1 bis 56) aus, die als Adressen für die in einem Speicher 91, der zum Filter 13 gehört, gespeicherten Eingangsabtastwerte 3a,b, c usw. wirken. Für jeden dieser Takte werden zudem über Leitung 34 aus der Modulobildungsschaltung 24 sogenannte m-Werte in eine Teilschaltung 43 eingegeben. Diese m-Werte sind Datenwörter die 15 Bit umfassen und den Zeitpunkt des für den betreffenden Takt wesentlichen Ausgangsabtastwertes (z. B. 12d) in bezug auf den Eingangsabtastwertraster bestimmen.

Die ersten 7-Bit des Datenwortes m geben für die Eingangsabtastwerte 3a, b, c usw. einen Wert s an, der die nächstgelegenen Filterkoeffizienten bezeichnet, die letzten 8-Bit geben den Abstand a zwischen dem nächstfolgenden Filterkoeffizienten 8 und dem Eingangsabtastwert 3h an. Somit gilt als Interpolationsformel für Filterkoeffizienten $C_i$

$$C_{i,a} = C_i + D_i \cdot a \text{ mit}$$
$$D_i = C_{i+1} - C_i \text{ und}$$
$$i = k \cdot v + s \text{ wobei}$$

k ein Faktor ist, der die verwendete Rasterung berücksichtigt, und $D_i$ die Differenz zwischen zwei benachbarten Filterkoeffizienten bezeichnet.

Die v-Werte werden dem Speicher 40 zugeführt und gelangen anschliessend in die Speicher 41 und 42. Nach der Teilschaltung 43 gelangen die a-Werte über Leitung 65 in den Speicher 42. Die s-Werte gelangen über den Inverter 44 in den Speicher 41. In diesem sind alle Filterkoeffizienten $C_i$ und alle Differenzen $D_i$ gespeichert. Die eintreffenden i-Werte, die im Speicher 44 aus den s-Werten und den v-Werten zusammengesetzt worden sind, gelten somit als Adressen für die betreffenden $C_i$- und $D_i$-Werte, die den Speicher 41 über die Leitungen 36 und 37 verlassen. Die $D_i$-Werte werden im Multiplikator 70 mit den a-Werten aus Leitung 35 multipliziert und anschliessend über Leitung 64 dem Additionsglied 71 zugeführt, wo sie mit dem $C_i$-Wert aus Leitung 37 kombiniert werden. Ein fertig interpolierter Filterkoeffizient $C_{i,a}$, verlässt das Additionsglied 71 über Leitung 59.

Da die Filterkoeffizienten 7 bezüglich der Filterachse 8 symmetrisch sind, ist nur deren erste Hälfte zu speichern. Deshalb wird im Speicher 40 die zweite Hälfte der Filterkoeffizienten umkodiert und im Inverter 44 die s-Werte für die zweite Hälfte der Filterkoeffizienten invertiert. Die v-Werte z. B. vom 56-sten Wert werden zurückgezählt und die a-Werte von dessen Maximalwert subtrahiert.

Im Betriebsfall b) in welchem die Ausgangsabtastrate kleiner ist als die Eingangsabtastrate, wird die Ausgangsabtastfolge mit zusätzlichen, als nullwertig angenommenen Abtastwerten versehen. Die Tätigkeit des Filters 13 und auch die Aufbereitung der Filterkoeffizienten ist auf die Eingangsabtastfolge synchronisiert. Dementsprechend geben die v-Werte Adressen für Produkte aus Eingangsabtastwerten und Filterkoeffizienten, die m-Werte den Zeitpunkt des für den betreffenden Takt wesentlichen Eingangsabtastwertes in bezug auf den Ausgangsabtastraster, an.

Um das Filter 13 und die Schaltung zur Aufbereitung der Filterkoeffizienten vom Betriebsfall a) auf den Betriebsfall b) umschalten zu können, ist die Steuerung 26 über eine Leitung 67, mit der Leitung 33 verbunden. Die Leitung 33 überträgt Daten, die das Verhältnis von Zeitdifferenzen $\frac{\Delta t_2}{\Delta t_1}$ bzw. $\frac{\Delta t_2}{\Delta t_1}$ zwischen aufeinanderfolgenden Abtastraten der Eingangs- bzw. der Ausgangsabtastfolge angeben. Aus diesen Daten kann abgeleitet werden, wann bei sich ändernden Abtastfrequenzen die Vorrichtung vom einen Betriebsfall in den anderen wechselt. Dies wird von der Steuerung 26 laufend erfasst. Beim Übergang von einer höheren Ausgangsabtastfrequenz als die Eingangsabtastfrequenz, können als Ausgangsabtastwerte im Speicher 14 gespeicherte Eingangsabtastwerte direkt verwendet werden, solange die Eingangsabtastfrequenz ungefähr der Ausgangsabstfrequenz entspricht. Diese werden über den Bypass 17 direkt dem Speicher 15 zugeleitet. Dieser Betriebszustand dauert 56 Takte, wenn für die Bildung eines Ausgangsabtastwertes 12, 56 Eingangsabtastwerte verwendet werden.

Beim Übergang von einer tieferen Ausgangsabtastfrequenz zu einer höheren Ausgangsabtastfrequenz als die Eingangsabtastfrequenz, ist sofortige Umschaltung möglich, da die Steuerung 26 so arbeitet, dass die Daten für höhere Ausgangsabtastfrequenzen ständig bereit sind. Die Speicher sind dann soweit mit Produkten aus Eingangsabtastwerten mit Filterkoeffizienten gefüllt, dass erste Ausgangsabtastwerte an den Speicher 15 ausgegeben werden können.

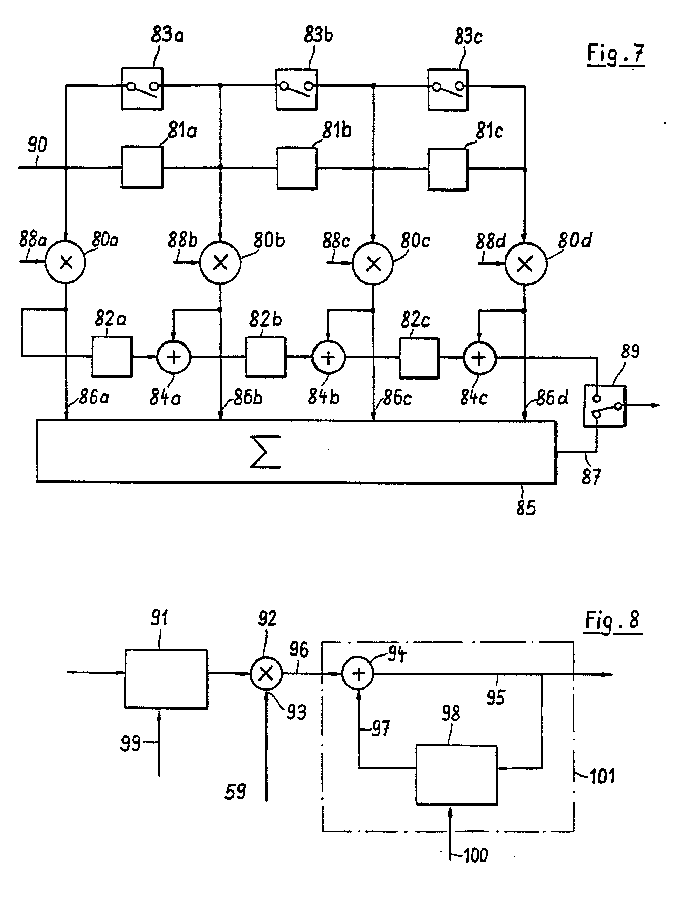

Aus Figur 7 ist eine mögliche Ausführungsform für ein Filter 13 ersichtlich. Die gezeigte Struktur des Filters 13 besteht in einer Kombination aus der 1. und der 2. kanonischen Struktur. Das Filter weist eine bestimmte Anzahl Multiplikatoren 80a, 80b, 80c, 80d usw. auf. Die Anzahl dieser Multiplikatoren 80 entspricht der Anzahl der Eingangsabtastwerte 3a, 3b, 3c, usw. (z. B. 56), die zur Berechnung eines Ausgangsabtastwertes 12d herangezogen werden. Entsprechend um Eins verringert ist die Anzahl von Zeitverzögerungsschaltungen oder Register 81a, b, c und 82a, b, c, die je zwischen zwei Multiplikatoren 80 angeordnet sind. Parallel zu den Registern 81a, b, c, sind Schalter 83a, b, c geschaltet. In Serie zu den Registern 82a, b, c usw. sind Addierglieder 84a, b, c angeordnet. Parallel zu den Multiplikatoren 80 ist ferner eine Summierschaltung 85 angeordnet. Jeder Multiplikator 80a, b, c weist auch einen Eingang 88a, b,c, d für die Filterkoeffizienten auf. Ein Umschalter 89 dient dem Umschalten des Filters 13 auf die Betriebszustände a) und b).

In jedem Arbeitstakt des Filters, d.h. zwischen dem Eintreffen zweier aufeinanderfolgender Abtastwerte 3a, b, c oder 12a, b, c usw. findet eine Multiplikation in den Multiplikatoren 80 und eine Addition entweder in der Summierschaltung 85 oder in den Addiergliedern 84 statt. In unserem Beispiel sind dies 56 Multiplikationen und Additionen die per Takt parallel durchgeführt werden. Im Betriebszustand a), wobei $\omega_2 > \omega_1$ ist, sind die Schalter 83a, b, c und 89 in der gezeichneten Stellung. Ein am Eingang 90 eintreffender erster Abtastwert wird einerseits dem Register 81a zugeleitet, wo er gespeichert bleibt, bis der zweite Abtastwert am Eingang 90 eintrifft und andererseits dem Multiplikator 80a zugeleitet in dem der Abtastwert mit einem Filterkoeffizienten multipliziert und der Summierschaltung 35 zugeführt wird. Beim Eintreffen des zweiten Abtastwertes am Eingang 90 wird dieser wiederum dem Multiplikator 80a und dem Register 81a zugeführt, das nun den ersten Abtastwert dem Multiplikator 80b zuführt usw. Beim Eintreffen eines Abtastwertes am Eingang 90 gibt die Summierschaltung 85 jeweils auch einen Ausgangsabtastwert über den Ausgang 87 ab, der aus einer Summe von vier aufeinanderfolgenden, je mit einem Filterkoeffizienten multiplizierten Eingangsabtastwerten besteht. In unserem Filter 13 sind dies nicht vier sondern sechsundfünfzig aufeinanderfolgende Abtastwerte die in einem Filter mit 56 Multiplikatoren und 55 Registern usw. summiert werden.

Im Betriebszustand b), wobei $\omega_1 > \omega_2$, sind die Schalter geschlossen und der Umschalter 89 in der nicht gezeichneten Stellung. Ein am Eingang 90 eintreffender Abtastwert liegt an allen Multiplikatoren 80 an und wird gleichzeitig mit allen Filterkoeffizienten multipliziert. Die so entstandenen vier Produkte werden wie folgt weiterbehandelt:

Aus dem Multiplikator 80a wird das erste Produkt in das Register 82a eingegeben. Aus den Multiplikatoren 80b, 80c und 80d gelangen die Produkte in die Addierglieder 84a, b, c. Dort wird das Produkt aus dem Multiplikator 80b mit einem Produkt aus dem Register 82a summiert. In einem weiteren Takt wird zu dieser Summe, die nun im Register 82b gespeichert ist im Addierglied 84b ein drittes Produkt aus dem Multiplikator 80c dazugezählt usw. Bei jedem Eintreffen eines neuen Abtastwertes am Eingang 90 wird über den Umschalter 89 eine Summe ausgegeben, die aus vier aufeinanderfolgenden Eingangsabtastwerten, welche je mit einem Filterkoeffizienten multipliziert sind, besteht.

Ist $\omega_2 > \omega_1$, so werden in den Registern 81a, b, c Eingangsabtastwerte schrittweise weitergegeben, der Ausgangsabtastwert wird für jeden Takt in der Summierschaltung 85 gebildet. Ist $\omega_1 > \omega_2$, so werden in den Registern 82a, b, c Teilsummen schrittweise weitergegeben und bei jedem Schritt mit einem neuen Wert ergänzt. Das Filter gemäss Figur 7 kann aber auch, wie aus Figur 8 ersichtlich, gestaltet werden. Es umfasst einen Speicher 91, einen einzigen Multiplikator 92 mit einem Eingang 93 für Filterkoeffizienten, ein Addierglied 94 mit einem Ausgang 95 und einem Eingang 96 und 97, wobei ein weiterer Speicher 98 zwischen dem Ausgang 95 und dem Eingang 97 eingeschaltet ist. Die Speicher 91 und 98 weisen zudem an sich bekannte Eingänge 99 und 100 für Speicheradressen auf. Das Addierglied 94 bildet mit dem Speicher 98 eine Akkumulatorschaltung 101.

Für den Betriebsfall a), wo $\omega_2 > \omega_1$ ist, werden im Speicher 91 eine Anzahl aufeinanderfolgender Abtastwerte (z. B. 56) auf entsprechende Speicherplätze ein gelesen. Ausgelesene Abtastwerte werden dem Multiplikator 92 zugeführt, dort mit einem Filterkoeffizienten multipliziert und anschliessend dem Addierglied 94 zugeführt. Im Speicher 98 wird nur ein Speicherplatz für einen einzigen Wert benützt. Innerhalb eines Taktes werden dabei beispielsweise alle sechsundfünfzig Abtastwerte aus dem Speicher 91 einmal ausgelesen, dem Multiplikator und dem Addierglied 94 zugeführt, wo diese Werte laufend akkumuliert werden. Im Speicher 98 wird jeweils ein Zwischenresultat der Akkumulation gespeichert. Sind alle Abtastwerte des Speichers 91 einmal ausgelesen, verschiebt sich der ganze Inhalt des Speichers 91 um einen Abtastwert und der genannte Vorgang beginnt erneut.

Für den Betriebsfall b), $\omega_1 > \omega_2$ ist, wird im Speicher 91 nur ein Speicherplatz für einen einzigen Abtastwert benützt, während im Speicher 98 alle Speicherplätze für (z. B. 56) mehrere Werte benützt werden. Ein bestimmter Abtastwert wird im selben Takt soviele male aus dem Speicher 91 entnommen und mit soviel Filterkoeffizienten im Multiplikator 92 multipliziert, wie im Speicher 98 Werte gespeichert sind (z. B. 56 mal). Vom Speicher 98 wird jeder Wert pro Takt einmal entnommen und im Addierglied 94 mit dem Produkt aus dem Multiplikator 92 addiert und wieder in den alten Speicherplatz eingelesen. Am Ende eines Taktes wird der älteste Wert aus dem Speicher 91 nach der Addition nicht mehr eingelesen, sondern über den Ausgang 95 ausgelesen. Ein neuer Abtastwert wird im Speicher 98 eingelesen und der ganze Speicherinhalt verschiebt sich um einen Speicherplatz bzw. einen Wert und diese Vorgänge beginnen von neuem.

In der Ausführung gemäss Figur 8 wird somit im Filter ein einziger Multiplikator im Zeitmultiplexverfahren betrieben. Das Umschalten vom Betriebszustand a) auf b) geschieht hier durch andere Zuordnung der Speicheradressen. Die Adressen die im Betriebsfall a) am Speicher 91 pro Takt angelegt werden, werden im Betriebsfall b) an den Speicher 100 angelegt.

## Patentansprüche

1. Verfahren zum Umsetzen der Abtastwerte einer Eingangsabtastfolge (1), die mit einer Eingangsabtastfrequenz auftreten, in Abtastwerte einer Ausgangsabtastfolge (10), die mit einer Ausgangsabtastfrequenz auftreten derart, dass die Eingangsabtastfolge und die Ausgangsabtastfolge Frequenzspektren aufweisen, die in einem Frequenzbereich amplitudenmässig im wesentlichen identisch sind, der sich von der Frequenz Null bis zur Hälfte der niedrigeren der beiden Abtastfrequenzen erstreckt, dadurch gekennzeichnet, dass eine feste Anzahl Werte (7) vorgegeben und gespeichert werden, die als feste Filterkoeffizienten eines einstufigen digitalen Transversalfilters oder Konstanten einer mathematischen Funktion vorgesehen sind, dass die Zeitdifferenz zwischen denjenigen Zeiten gemessen wird, zu denen Eingangsabtastwerte (3a bis h) einerseits und Ausgangsabtastwerte (12a bis d) andererseits auftreten, dass zu bestimmten Abtastzeiten benötigte Filterkoeffizienten (9, 9') aus den fest gespeicherten Werten und aus der gemessenen Zeitdifferenz berechnet werden und dass die Eingangsabtastfolge (1) mit Hilfe der berechneten Filterkoeffizienten gefiltert wird, so dass daraus die gewünschte Ausgangsabtastfolge (10) entsteht.

2. Verfahren gemäss Anspruch 1, dadurch gekennzeichnet, dass die zu bestimmten Abtastzeiten benötigten Filterkoeffizienten (9, 9') durch Interpolation aus der festen Anzahl Werte (7), die Filterkoeffizienten darstellen, berechnet werden.

3. Verfahren gemäss Anspruch 1, dadurch gekennzeichnet, dass die zu bestimmten Abtastzeiten benötigten Filterkoeffizienten durch Berechnung von Werten der gegebenen mathematischen Funktion fuer diese Abtastzeitpunkte berechnet werden.

4. Verfahren gemäss Anspruch 1, dadurch gekennzeichnet, dass der Abtastfolge mit der tieferen Abtastfrequenz weitere Abtastwerte (4a, 4b, 4c) zugefuegt werden, die eine Signalamplitude gleich null aufweisen.

5. Verfahren gemäss Anspruch 4, dadurch gekennzeichnet, dass die feste Anzahl Filterkoeffizienten dem Produkt aus derjenigen Anzahl von Eingangsabtastwerten, welche zur Berechnung eines Ausgangsabtastwertes herangezogen werden, und der Anzahl weiterer Abtastwerte zwischen zwei Abtastwerten einer Abtastfolge entspricht.

6. Verfahren gemäss Anspruch 1, dadurch gekennzeichnet, dass als Werte Konstanten einer Prototypfunktion sowie Konstanten einer Fenster-Funktion gespeichert werden, wobei eine multiplikative Kopplung der Prototypfunktion mit der Fenster-Funktion vorgesehen ist.

7. Verfahren gemäss Anspruch 2, dadurch gekennzeichnet, dass als Interpolation lineare Interpolation verwendet wird.

8. Vorrichtung zur Durchführung des Verfahrens gemäss Anspruch 1, gekennzeichnet durch, ein digitales Filter (13) sowie eine Schaltung (22, 23, 24, 25) zum unmittelbaren Berechnen von benötigten Filterkoeffizienten (9, 9') aus der relativen Zeitdifferenz zwischen Ein- und Ausgangsabtastwerten (3, 12) und aus fest gespeicherten Werten (7).

9. Vorrichtung gemäss Anspruch 8, dadurch gekennzeichnet, dass als Schaltung zum unmittelbaren Berechnen der Filterkoeffizienten eine, mit einer Zeitmeßschaltung (22) kombinierte Interpolationsschaltung (25) vorgesehen ist.

10. Vorrichtung gemäss Anspruch 8, gekennzeichnet durch Speicher (14, 15) dem digitalen Filter (13) vor und nachgeschaltet, sowie durch einen Bypass (17) zur Überbrückung des digitalen Filters (13).

11. Vorrichtung gemäss Anspruch 8, gekennzeichnet durch eine, dem digitalen Filer (13) zugeschaltete Kompensationsschaltung (23) zur Kompensation von Abtastfrequenzänderungen.

12. Vorrichtung gemäss Anspruch 8, dadurch gekennzeichnet, dass als digitales Filter (13) eine Serieschaltung eines Speichers (91), eines Multiplikators (92) und einer Akkumulationsschaltung (101) vorgesehen ist.

13. Vorrichtung gemäss Anspruch 12, dadurch gekennzeichnet, dass die Akkumulationsschaltung (101) aus einem Addierglied (94) und einem Speicher (91) besteht.

14. Vorrichtung gemäss Anspruch 8, dadurch gekennzeichnet, dass das Filter (13) zum wahlweisen Betrieb gemäss einer 1. und einer 2. kanonischen Struktur ausgebildet ist.

## Claims

1. Method to convert samples of a sampled input signal sequence (7) occurring with an input sampling frequency, into samples of an output signal sequence (10) occurring with an output sampling frequency, in such a way that the sampled input signal sequence and the sampled output signal sequence have frequency spectra, which are substantially identical from the amplitude standpoint in a frequency range extending from the frequency zero to half the lower of the two sampling frequencies, characterised in that a fixed set of values (7) which are taken as fixed coefficients for a digital one-stage filter or as constants of a mathematical function is determined and stored, in that a time difference is measured between times at which input samples (3a to h) appear and times at which output samples (12a to d) are needed, in that filter coefficients (9, 9') needed at specific sampling times are calculated from said set of stored values and said time difference, and in that said input signal sequence (1) is filtered using said calculated filter coefficients, for obtaining the desired sampled output signal sequence (10).

2. Method according to claim 1, wherein filter coefficients (9, 9') needed at specific sampling times are calculated from said set of fixed values (7), which represent filter coefficients, by interpolation.

3. Method according to claim 1, wherein filter coefficients needed at specific sampling times are calculated by calculating values of said mathematical function.

4. Method according to claim 1, wherein further samples (4a, 4b, 4c) which have a signal amplitude of zero are added to the sampled signal sequence with the lower of the two sampling frequencies.

5. Method according to claim 4, wherein the number of coefficients of said fixed set corresponds to the product of the number of input samples used for calculating an output sample and the number of further samples added between two samples of a sampled signal sequence.

6. Method according to claim 1, wherein said stored values are constants of a prototype function and constants of a window function and wherein both functions are coupled by multiplication.

7. Method according to claim 2, wherein linear interpolation is used for interpolating.

8. Device for carrying out the method according to claim 1, comprising a digital filter (73) and a circuit (22, 23, 24, 25) for the direct calculation of the necessary filter coefficients (9, 9') from the relative time difference between the input and output samples and from stored values (7).

9. Device according to claim 8, wherein an interpolation circuit (25) combined with a time measuring circuit (22) is used as the circuit for the direct calculation of the filter coefficients.

10. Device according to claim 8, wherein stores (14, 15) are connected upstream and downstream of the digital filter (13) and a bypass (17) is provided for bridging the digital filter (13).

11. Device according to claim 8, wherein a compensating circuit (23) for compensating the sampling frequency changes is connected into the digital filter (13).

12. Device according to claim 8, wherein a series connection of a store (91), a multiplier (92) and an accumulator circuit (101) is provided as the digital filter.

13. Device according to claim 12, wherein the accumulator circuit (101) comprises an adding element (94) and a store (97).

14. Device according to claim 8, wherein the filter (13) is constructed for random operation in accordance with a first and second canonic structure.

## Revendications

1. Procédé pour convertir les échantillons d'une série d'échantillonnage d'entrée (1) ayant une fréquence d'échantillonnage d'entrée en échantillons d'une série d'échantillonnage de sortie (10) ayant une fréquence d'échantillonnage de sortie, de telle manière que les deux séries d'échantillonnage présentent des spectres de fréquence dont les amplitudes sont essentiellement identiques dans un domaine de fréquences qui s'étend depuis la fréquence zéro jusqu'à la moitié de la plus basse des deux fréquences d'échantillonnage, caractérisé en ce que des valeurs (7) sont données et mémorisées en nombre fixe et, sont prévues comme coefficients fixes d'un filtre transversal à un étage ou comme constantes d'une fonction mathématique, en ce que la différence de temps entre les moments où les échantillons d'entrée (3a à h) et les échantillons de sortie (12a à d) apparaissent est mesurée, en ce que des coefficients (9, 9') désirés en des moments déterminés sont calculés à partir de ces valeurs fixes et de la différence de temps mesurée et en ce que la série d'échantillonnage d'entrée (1) est filtré à l'aide de coefficients afin d'obtenir la série d'échantillonnage de sortie (10) désirée.

2. Procédé selon la revendication 1, caractérisé en ce que les coefficients (9, 9') désirés en des moments déterminés sont calculés par interpolation à partir du nombre fixe des valeurs (7), qui représentent des coefficients.

3. Procédé selon la revendication 1, caractérisé en ce que les coefficients désirés en des moments déterminés sont calculés comme des valeurs de la fonction mathématique donnée.

4. Procédé selon la revéndication 1, caractérisé en ce que les échantillons supplémentaires (4a, 4b, 4c) d'une valeur zéro sont ajoutés à la série d'échantillonnage avec la fréquence d'échantillonnage la plus basse.

5. Procédé selon la revendication 4, caractérisé en ce que le nombre fixe de valeurs est égal au produit du nombre des échantillons d'entrée qui sont utilisés pour calculer un échantillon de sortie et du nombre d'échantillons supplémentaires ajoutés entre deux échantillons d'une série d'échantillonnage.

6. Procédé selon la revendication 1, caractérisé en ce que des constantes d'une fonction prototype et des constantes d'une fonction qui définit une fenêtre sont mémorisées en tant que valeurs fixes et en ce que la fonction prototype est accouplée par multiplication à la fonction fenêtre.

7. Procédé selon la revendication 2, caractérisé en ce que l'interpolation est une interpolation linéaire.

8. Appareil pour exécuter le procédé selon la revendication 1, caractérisé par un filtre numérique (13) ainsi qu'un circuit (22, 23, 24, 25) pour calculer les coefficients (9, 9') nécessaires à partir de la différence de temps relative entre échantillons d'entrée et de sortie (3, 12) et à partir de valeurs fixes (7).

9. Appareil selon la revendication 8, caractérisé en ce que le circuit pour calculer les coefficients se compose d'un circuit (22) pour mesurer le temps et d'un circuit d'interpolation (25) combiné.

10. Appareil selon la revendication 8, caractérisé par des mémoires (14, 15) qui précèdent et qui suivent le filtre numérique (13) et par un bipasse (17) pour contourner le filtre (13).

11. Appareil selon la revendication 8, caractérisé par un circuit de compensation (23) accouplé au filtre numérique (13) pour compenser les variations de fréquence d'échantillonnage.

12. Appareil selon la revendication 8, caractérisé en ce que le filtre numérique (13) se compose d'un arrangement en série d'une mémoire (91), d'un multiplieur (92) et d'un circuit accumulateur (101).

13. Appareil selon la revendication 12, caractérisé en ce que le circuit accumulateur (101) se compose d'un additionneur (94) et d'une mémoire (91).

14. Appareil selon la revendication 8, caractérisé en ce que le filtre numérique (13) est conçu pour fonctionner à choix selon une structure canonique de premier ou de second ordre.

EP 0 137 323 B1

Fig. 1

Fig. 2

Fig. 3

Fig. 4

EP 0 137 323 B1

EP 0 137 323 B1

Fig. 5

Fig. 6

5

Fig.7

Fig.8